(19) Europäisches Patentamt

European Patent Office

Office européen des brevets

(11) Numéro de publication: **0 228 941**
**B1**

(12) **FASCICULE DE BREVET EUROPEEN**

(51) Int. Cl.⁴: **H03B 5/20**

(45) Date de publication du fascicule du brevet:
**25.04.90**

(21) Numéro de dépôt: **86402688.5**

(22) Date de dépôt: **03.12.86**

(54) **Oscillateur sinusoidal à très faible distorsion.**

(30) Priorité: **06.12.85 FR 8518114**

(43) Date de publication de la demande:
**15.07.87 Bulletin 87/29**

(45) Mention de la délivrance du brevet:
**25.04.90 Bulletin 90/17**

(84) Etats contractants désignés:
**DE FR GB IT NL SE**

(56) Documents cités:
**DE-A- 3 107 446**

**IEEE JOURNAL OF SOLID-STATE CIRCUITS, vol.
SC-18, no. 4, août 1983, pages 383-389, IEEE, New York,
US; D.B. COX: "A digitally programmable
switched-capacitor universal active filter/oscillator"**

(73) Titulaire: **SGS-THOMSON MICROELECTRONICS S.A., 7,
Avenue Galliéni, F-94250 Gentilly(FR)**

(72) Inventeur: **Caillon, Christian, Thomson-CSF
SCPI 19 avenue, de Messine, F-75008 Paris(FR)**
Inventeur: **Terrier, Christian, Thomson-CSF
SCPI 19 avenue, de Messine, F-75008 Paris(FR)**

(74) Mandataire: **Rinuy, Santarelli, 14, avenue de la Grande
Armée, F-75017 Paris(FR)**

## Description

L'invention concerne les oscillateurs sinusoïdaux, qui sont des circuits électroniques capables de fournir un signal électrique sinusoïdal à une fréquence et une amplitude choisies et controlées.

La qualité d'un tel oscillateur dépend de la stabilité de la fréquence obtenue et de la pureté de la sinusoïde ; cette pureté s'exprime par le taux de distorsion du signal, qui représente pratiquement la proportion d'énergie contenue dans la composante purement sinusoïdale à la fréquence de base Fo du signal par rapport à l'énergie totale du signal ; le taux de distorsion devient plus faible que l'unité s'il y a dans le spectre de fréquences du signal des composantes à des fréquences différentes de la fréquence de base Fo.

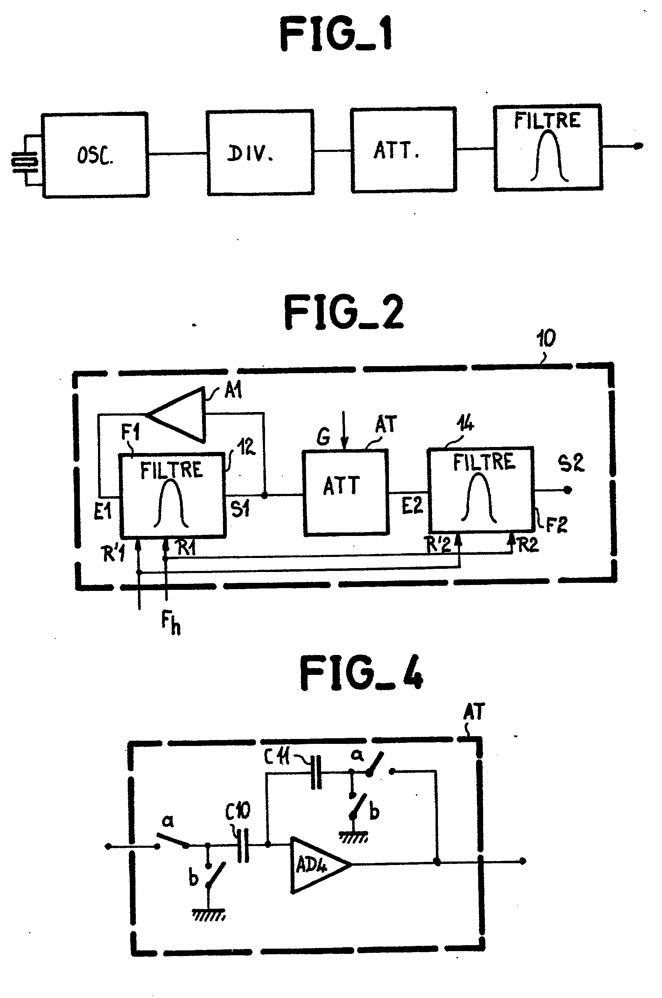

C'est pourquoi, pour obtenir un oscillateur à fréquence sinusoïdale très pure, on a déjà proposé d'utiliser un oscillateur à quartz suivi en général d'un diviseur de fréquence, lui-même suivi d'un atténuateur et enfin d'un filtre à haute sélectivité (figure 1).

Le quartz fournit une fréquence de base très stable pour répondre aux exigences de stabilité. Le diviseur de fréquence permet d'obtenir la fréquence désirée si le quartz oscille à une fréquence différente de la fréquence désirée ; la stabilité de fréquence n'est pas détériorée par le diviseur. L'atténuateur limite si cela est nécessaire l'amplitude du signal mais ne détériore pas la stabilité de la fréquence. Le signal à la sortie du diviseur et à la sortie de l'atténuateur n'est pas sinusoïdal ; il est plutôt rectangulaire, c'est-à-dire qu'il contient beaucoup d'harmoiques de la fréquence de base. C'est pourquoi on prévoit un filtre à haute sélectivité pour éliminer ces harmoniques et aboutir à un signal sinusoïdal stable et très peu distordu. Le filtre a une courbe de réponse à bande passante très étroite, centrée sur la fréquence désirée c'est-à-dire centrée sur la fréquence de sortie du diviseur.

Ce type d'oscillateur répond aux critères de stabilité et de distorsion requis.

Mais il a l'inconvénient de nécessiter un quartz, élément qui n'est pas intégrable dans une pastille semiconductrice.

Le remplacement de cet oscillateur à quartz par un oscillateur intégrable de type quelconque aboutit à un accroissement de la distorsion car il y a un risque. de désaccord entre la fréquence de l'oscillateur et la fréquence centrale du filtre sélectif de sortie, désaccord qui entraine une moins bonne suppression des harmoniques de la fréquence de base.

La demanderesse s'étant aperçue de ce problème propose une nouvelle structure d'oscillateur sinusoïdal qui d'une part ne comporte pas de risque de désaccord entre le générateur et le filtre de sortie, d'autre part est très facilement intégrable, et enfin fournit un signal sinusoïdal très pur.

Selon l'invention, l'oscillateur sinusoïdal comprend sur une pastille unique de circuit intégré un premier filtre passe-bande sélectif présentant un maximum de transmission pour une fréquence centrale désirée Fo, ce filtre ayant une entrée et une sortie, une boucle de réaction étant prévue entre la sortie et l'entrée pour faire osciller le filtre à la fréquence Fo, un deuxième filtre passe-bande sélectif absolument identique au premier ayant une entrée reliée directement ou par l'intermédiaire d'un atténuateur à la sortie du premier filtre et une sortie constituant la sortie de l'oscillateur sinusoïdal.

Chacun des deux filtres a de préférence une entrée de réglage de fréquence centrale et un signal de réglage commun est alors appliqué simultanément sur l'entrée de réglage du premier filtre et sur l'entrée de réglage du second filtre.

De préférence les filtres sont des filtres à capacités commutées fonctionnant à l'aide d'un signal d'horloge, et le signal d'horloge constitue alors un signal de réglage de fréquence centrale ; ce signal d'horloge est appliqué simultanément aux deux filtres identiques. Il peut être généré par un quartz.

De plus, on prévoit de préférence dans des cas particuliers que la fréquence centrale de chacun des filtres sélectifs peut être modifiée par mise en service dans ces filtres de capacités de valeurs diverses, la mise en service étant effectuée par action sur un ou plusieurs interrupteurs dont l'ouverture ou la fermeture sont commandés par un signal qui est commun aux deux filtres.

Grâce à ces particularités de structure on obtient un oscillateur fournissant une sinusoïde très pure dont la fréquence peut être très facilement réglée.

En effet, il est facile de réaliser deux filtres de courbes de réponse pratiquement identiques sur une même puce de circuit intégré : il suffit de réaliser des structures de filtres identiques dans leur configuration (y compris dans leur topographie exacte). Dans ces conditions, le premier filtre va osciller à une fréquence qui correspond au maximum de sa courbe de réponse, qui est très exactement le maximum de la courbe de réponse du deuxième filtre. L'écart entre les deux maxima est en effet très faible car il correspond aux tolérances de fabrication d'éléments identiques sur une même pastille de circuit : la précision peut être très grande.

Le taux de réjection des fréquences différentes de la fréquence d'oscillation est donc le meilleur possible.

De plus, si la fréquence des filtres est réglable, on conçoit que l'utilisation d'un même signal de réglage pour les deux filtres conserve la qualité de la sinusoïde obtenue indépendamment du changement de fréquence, ce qui ne serait pas le cas avec d'autres types d'oscillateur.

Le signal de réglage est particulièrement facile à obtenir avec des filtres à capacités commutées puisqu'il peut être constitué par le signal d'horloge assurant la commutation des capacités des filtres.

Enfin, que le signal d'horloge soit fixe ou variable, un changement de fréquence centrale peut être obtenu de manière très commode par mise en service de capacités de valeurs différentes dans les filtres, les mêmes capacités étant bien entendu mises en service dans les deux filtres simultanément.

En pratique une très bonne qualité de sinusoïde peut être obtenue avec deux filtres passe-bande du deuxième ordre, c'est-à-dire des filtres dont la transformée en z (qui représente la courbe de réponse) est un rapport de deux polynômes en z, celui du dénominateur étant du second degré et celui du numérateur étant de degré inférieur ou égal à deux.

D'autres caractéristiques et avantages de l'invention apparaîtront à la lecture de la description détaillée qui suit et qui est faite en référence aux dessins annexés dans lesquels :

- la figure 1 représente un oscillateur sinusoïdal de l'art antérieur,
- la figure 2 représente un schéma d'oscillateur selon l'invention,
- la figure 3 représente un schéma détaillé d'un filtre utilisé dans un exemple de réalisation de l'invention.
- la figure 4 représente l'atténuateur utilisé dans cet exemple.

On ne reviendra pas sur la description déjà faite de la figure 1 qui représente un art antérieur connu pour des oscillateurs à haute stabilité et faible dispersion.

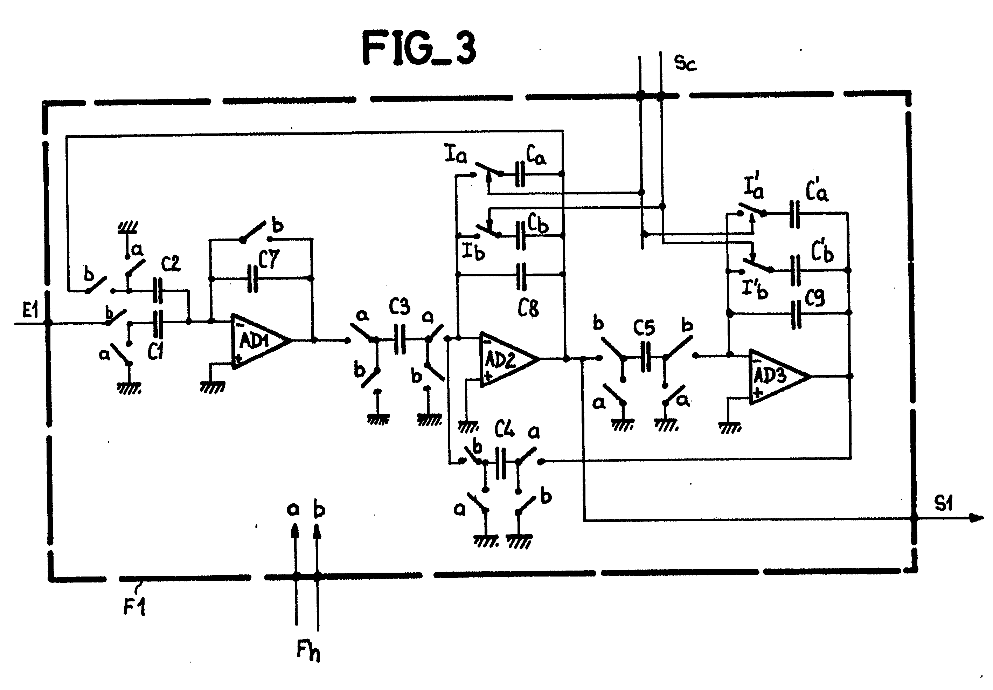

La structure générale de l'oscillateur selon l'invention est représentée à la figure 2.

Cet oscillateur, représenté à l'intérieur d'un bloc 10 en traits tiretés, est réalisé entièrement sur une pastille unique de circuit intégré afin que les caractéristiques de structure et de topographie des deux filtres qu'il comporte soient rigoureusement identiques aux tolérances de fabrication près. Ces tolérances sont minimisées puisque les deux filtres sont construits sur une même pastille de circuit intégré.

Les deux filtres identiques sont désignés par les références 12 et 14. Ce sont des filtres passe-bande sélectifs dont la courbe de réponse comporte un pic de transmission à une fréquence centrale Fo bien précise (mais qui peut être variable pourvu que la variation soit rigoureusement la même pour les deux filtres).

Par filtre sélectif on entend ici un filtre passe-bande dont la courbe de transmission dans la bande-passante n'est pas plate mais présente un maximum bien marqué à la fréquence centrale Fo, la bande passante étant étroite autour de cette fréquence centrale, de sorte que le taux de réjection des fréquences harmoniques de la fréquence Fo soit élevé.

Un ordre de grandeur de sélectivité appropriée est Q = 50 où Q est le rapport entre la fréquence centrale Fo et la bande passante dans laquelle l'atténuation est inférieure à 3 décibels par rapport à l'atténuation à la fréquence centrale.

Le premier filtre 12 comporte une entrée E1, une sortie S1 et une boucle de réaction reliant la sortie S1 à E1 de manière à faire osciller le filtre dès lors qu'il est alimenté en énergie. La boucle de réaction est une simple liaison conductrice, ou bien elle comprend des éléments de circuit propres à assurer un déphasage et/ou une amplification adéquats pour faire osciller le filtre à la fréquence correspondant au pic de transmission de la courbe de réponse du filtre. Ces éléments de circuit sont symbolisés par un amplificateur A1 sur la figure 2.

La sortie S1 du premier filtre F1 est reliée à travers un atténuateur AT à l'entrée E2 du deuxième filtre F2, et la sortie S2 de ce deuxième filtre constitue la sortie du générateur sinusoïdal 10.

On prévoit de préférence que l'atténuateur possède une entrée G de réglage de gain de sorte que le signal de sortie du générateur soit réglable en amplitude.

Dans la majorité des cas on souhaitera également que le générateur sinusoïdal soit réglable en fréquence. Dans ce cas, chacun des deux filtres comporte une entrée de réglage respective, R1 pour le filtre F1 et R2 pour le filtre F2, ces deux entrées recevant un signal de réglage commun agissant sur la forme de la courbe de transmission des filtres pour déplacer la fréquence centrale Fo correspondant au pic de transmission. La variation de la fréquence centrale est rigoureusement la même pour les deux filtres aux tolérances de fabrication près.

Dans une réalisation préférée, les filtres sont des filtres à capacités commutées et le signal de réglage de la fréquence centrale est principalement constitué par un signal d'horloge qui commande la commutation de toutes les capacités commutées des deux filtres ; une modification de la fréquence Fh de commutation des capacités entraine une translation (essentiellement sans modification de forme générale) de la courbe de réponse des filtres le long de l'axe des fréquences ; le signal d'horloge est donc bien un signal de réglage de la fréquence centrale des filtres sélectifs.

On peut prévoir en outre une deuxième manière de modifier la fréquence du générateur sinusoïdal, cette modification pouvant être faite soit à la place soit en plus de la modification par le signal d'horloge : une deuxième entrée de réglage, R'1 pour le premier filtre, R'2 pour le deuxième, reçoit une commande logique Sc (et non plus un signal d'horloge). Cette commande logique Sc est la même pour les deux filtres et elle commande la fermeture ou l'ouverture d'interupteurs pour la mise en service de capacités de valeurs différentes.

Par exemple la commande logique comprend deux signaux logiques (fournissant donc une information sur deux bits). L'un des signaux commande la mise en service d'une capacité Ca et l'autre la mise en service d'une capacité Cb de sorte que selon l'état de la commande on peut mettre en service une capacité Ca ou Cb ou Ca + Cb ou une capacité nulle. Les capacités Ca et Cb sont bien entendu les mêmes pour chaque filtre et les signaux de commande agissent de la même manière sur les deux filtres. Ces capacités sont connectées à un endroit où elles influent directement sur la courbe de réponse des filtres et plus particulièrement sur la fréquence centrale. On verra notamment que les filtres à capacités commutées comprennent le plus souvent au moins un amplificateur monté en intégrateur, c'est-à-dire ayant une capacité non commutée reliée entre la sortie et l'entrée de l'amplificateur ; les capacités Ca et Cb sont alors connectées en parallèle avec cette capacité non commutée, ou déconnectées, selon l'état des signaux de commande. Le signal de commande logique Sc à deux bits permet d'obtenir quatre fréquences d'oscillation différentes.

Dans le cas général des filtres à capacités commutées on prévoira en outre un filtre passe-bas non échantillonné en aval de la sortie 52, pour éliminer les composantes de fréquences situées autour de la fréquence d'horloge Fh. Cette fréquence est de préférence très largement supérieure à la fréquence centrale désirée Fo ; par exemple Fh est de l'ordre de 50 Fo.

On va maintenant décrire un exemple de réalisation détaillée dans lequel les filtres sont des filtres à capacités commutées d'ordre 2 et ont une fonction de transfert de la forme

$$\frac{A\ Fo\ p}{Fo^2 + 2BFoP + p^2}$$

où p est la variable de Laplace, Fo la fréquence centrale, et où A et B sont des coefficients.

Sur le schéma de la figure 3 on a représenté le filtre F1, étant entendu que le filtre F2 est rigoureusement identique dans sa structure et dans ses caractéristiques numériques (valeurs des capacités notamment) et étant entendu qu'il reçoit le même signal d'horloge Fh et les mêmes signaux de commande Sc.

La figure 4 représente la structure de l'atténuateur. Le générateur utilise le filtre de la figure 3 et l'atténuateur de la figure 4 et il a la structure générale de la figure 2 complétée par la présence d'un filtre passe-bas non échantillonné relié à la sortie S2.

Le signal d'horloge Fh comporte en pratique deux phases a et b et chaque phase actionne périodiquement à la fréquence Fh un certain nombre de commutateurs dans le circuit de la figure 3. On a représenté en face de chaque commutateur la phase a ou b pendant laquelle ce commutateur est fermé.

Le filtre de la figure 3 n'est donné qu'à titre d'exemple.

Il comprend trois amplificateurs différentiels AD1, AD2, AD3 ayant chacun une entrée non inverseuse reliée à une masse et une entrée inverseuse reliée à une ou plusieurs capacités commutées ou non commutées.

La capacité commutée C1 a une armature reliée à l'entrée inverseuse de l'amplificateur AD1 et une autre armature qui peut être reliée à l'entrée E1 (phase b) ou à la masse (phase a).

La capacité C2 a une borne reliée à l'entrée inverseuse de AD1 et une autre qui peut être reliée à la sortie de AD2 (phase b) ou à la masse (phase a).

La capacité C3 a une borne qui peut être reliée à la sortie de AD1 (phase a) ou à la masse (phase b) et une autre borne qui peut être reliée à l'entrée inverseuse de AD2 (phase a) ou à la masse (phase b).

La capacité C4 a une borne qui peut être reliée à l'entrée de AD2 (phase b) ou à la masse (phase a) et une autre borne qui peut être reliée à la sortie de AD3 (phase a) ou à la masse (phase b).

La capacité C5 a une borne qui peut être reliée à la sortie de AD2 (phase b) ou à la masse (phase a) et une autre borne qui peut être reliée à l'entrée inverseuse de AD3 (phase b) ou à la masse (phase a). Les capacités C3, C4, C5 ont des valeurs identiques.

La capacité C7 est reliée en parallèle entre la sortie et l'entrée de AD1 et peut être court-circuitée pendant la phase b.

La capacité C8 est reliée en parallèle entre la sortie et l'entrée de AD2.

La capacité C9 est reliée en parallèle entre la sortie et l'entrée de AD3 ; C8 et C9 ont des valeurs identiques ; la sortie S1 du filtre F1 est prise à la sortie de l'amplificateur AD2.

Enfin, plusieurs capacités sont prévues en parallèle sur la capacité C8 et d'autres, identiques, en parallèle sur C9. Ces capacités peuvent être mises en service ou déconnectées par des interrupteurs Ia, Ib, I'a, I'b respectivement qui ne sont pas actionnés périodiquement par les phases a et b mais qui sont fermés ou ouverts selon les signaux de commande Sc (non périodiques a priori).

Ces signaux de commande Sc permettent de modifier la valeur de la fréquence centrale du filtre en modifiant la valeur de la capacité totale qui est placée en parallèle avec les capacités C8 et C9 pendant le fonctionnement du filtre.

Dans l'exemple représenté on a prévu deux bits de commande pour le signal Sc et par conséquent deux capacités Ca et Cb en parallèle sur C8 et deux autres capacités C'a et C'b (respectivement égales à Ca et Cb) en parallèle sur C9.

Selon l'état logique des bits du signal Sc on a quatre possibilités de fréquence centrale du filtre car les capacités en parallèle avec les amplificateurs AD2 et AD3 peuvent prendre les quatre valeurs suivantes :

C8 = C9
C8 + Ca = C9 + C'a
C8 + Cb = C9 + C'b
C8 + Ca + Cb = C9 + C'a + C'b

L'atténuateur placé entre les filtres est représenté à la figure 4 ; c'est un atténuateur à capacités commutées mais il pourrait être réalisé tout à fait différemment, par exemple par un inverseur logique alimenté par une tension variable.

Le schéma de la figure 4 comprend un amplificateur différentiel AD4 ayant une entrée non-inverseuse reliée à la masse et une entrée inverseuse reliée à une borne d'une capacité C10 dont l'autre borne peut être reliée à la sortie du filtre F1 (phase a) ou à la masse (phase b) ; une autre capacité C11 a une extrémité reliée à l'entrée de AD4 et une autre reliée soit à sa sortie (phase a) soit à la masse (phase b). Le rapport des capacités C11 et C10 règle l'atténuation ; ce rapport peut être modifié par mise en service de capacités en parallèle avec C11 de la même manière que des capacités Ca et Cb sont mises en parallèle avec C8, mais sous la commande d'un signal de réglage de gain G déjà mentionné en référence à la figure 2.

Pour terminer la description de cet exemple de générateur sinusoïdal réalisé à partir de deux filtres à capacités commutées il faut préciser qu'une filtre passe-bas de lissage doit être prévu. Ce filtre est un filtre non échantillonné ; par exemple il est constitué d'un réseau RC série connecté entre la sortie S2 et la masse, la sortie de ce filtre de lissage (qui constitue la sortie du générateur sinusoïdal) étant prise au point de jonction de la résistance et de la capacité de ce réseau RC. La fréquence de coupure de ce filtre doit être nettement supérieure à la fréquence centrale Fo désirée pour le générateur (pour qu'il n'y ait pas d'atténuation à cette fréquence) et très inférieure à la fréquence d'horloge Fh pour que les composantes de fréquences voisines de cette fréquence d'horloge soient très affaiblies. Pour que ce choix soit possible, on prévoit comme déjà indiqué ci-dessus que Fh est très supérieur à Fo.

**Revendications**

1. Oscillateur sinusoïdal caractérisé en ce qu'il comprend, sur une même pastille de circuit intégré un premier filtre passe-bande sélectif (F1) présentant un maximum de transmission pour une fréquence centrale Fo et ayant une entrée (E1) et une sortie (S1), une boucle de réaction (A1) reliant la sortie à l'entrée pour constituer un oscillateur à la fréquence Fo, un deuxième filtre passe-bande sélectif (F2) identique au premier et ayant une entrée (E2) reliée directement ou par l'intermédiaire d'un atténuateur (ATT) à la sortie du premier filtre et une sortie (S2) constituant la sortie de l'oscillateur sinusoïdal.

2. Oscillateur sinusoïdal selon la revendication 1, caractérisé en ce que chaque filtre comporte une entrée de réglage de fréquence (R1 resp. R2) et en ce qu'un signal (Fh) de réglage de fréquence commun est appliqué simultanément à l'entrée de réglage de chacun des deux filtres.

3. Oscillateur sinusoïdal selon la revendication 2, caractérisé en ce que les filtres sont des filtres à capacités commutées fonctionnant à l'aide d'un signal d'horloge et en ce que le signal d'horloge constitue un signal de réglage de fréquence.

4. Oscillateur sinusoïdal selon l'une des revendications 2 et 3, caractérisé en ce que ce les filtres sont des filtres à capacités commutées fonctionnant à l'aide d'un signal d'horloge et comportent chacun au moins une capacité en série avec un interrupteur qui n'est pas actionné à la fréquence de signal d'horloge et en ce qu'un signal de réglage de fréquence des filtres est constitué par un signal de commande de fermeture ou d'ouverture de cet interrupteur, la fréquence centrale de transmission du filtre étant modifiée selon que ʼl'interrupteur est ouvert ou fermé.

**Patentansprüche**

1. Sinusoszillator, dadurch gekennzeichnet, daß er auf demselben IC-Chip einen ersten selektiven Bandfilter (F1) mit einem Übertragungsmaximum bei einer mittleren Trägerfrequenz Fo und einem Eingang (E1) sowie einem Ausgang (S1), eine Rückkopplungsschleife (A1), die zu Bildung eines Oszillators der Frequenz Fo den Ausgang mit dem Eingang verbindet, sowie einen zweiten selektiven Bandfilter (F2) aufweist, der mit dem ersten identisch ist und einen direkt oder unter Zwischenschaltung eines Dämpfungsgliedes (ATT) an den Ausgang des ersten Filters angeschlossenen Eingang sowie einen Ausgang (S2) aufweist, der den Ausgang des Sinusoszillators bildet.

2. Sinusoszillator nach Anspruch 1, dadurch gekennzeichnet, daß jeder Filter einen Frequenzregeleingang (R1 bzw. R2) aufweist und ein gemeinsames Frequenzregelsignal (Fh) gleichzeitig an den Frequenzregeleingang jedes der beiden Filter angelegt wird.

3. Sinusoszillator nach Anspruch 2, dadurch gekennzeichnet, daß die Filter Filter mit umschaltbaren Bereichen sind, die über ein Taktgebersignal arbeiten, und daß das Taktgebersignal ein Frequenzregelsignal bildet.

4. Sinusoszillator nach einem der Ansprüche 2 und 3, dadurch gekennzeichnet, daß die Filter Filter mit umschaltbaren Bereichen sind, die über ein Taktgebersignal arbeiten und deren jeder mindestens eine Kapazität in Serie mit einem Unterbrecher aufweist, der bei der Frequenz des Taktgebersignals nicht betätigt wird, und daß ein Regelsignal für die Frequenz der Filter von einem Steuersignal zum Schließen oder Öffnen dieses Unterbrechers gebildet wird, wobei die mittlere Trägerfrequenz der Filterübertragung in Abhängigkeit davon, ob der Unterbrecher offen oder geschlossen ist, geändert wird.

**Claims**

1. A sinusoidal oscillator, characterized in that it comprises on a single integrated circuit chip a first selective band-pass filter (F1) having a transmission maximum at a central frequency Fo and comprising an input (E1) and an output (S1), a feedback loop (A1) which connects the input and the output to form an oscillator at the frequency Fo, a second selective band-pass filter (F2) identical to the first and comprising an input (E2) which is connected directly or through the intermediary of an attenuator (ATT) to the output of the first filter, and an output (S2) which constitutes the output of the sinusoidal oscillator.

2. A sinusoidal oscillator according to claim 1, characterized in that each filter comprises a frequency adjustment input (R1 and R2 respectively) and in that a common frequency adjustment signal (Fh) is applied simultaneously to the adjustment inputs of each of the two filters.

3. A sinusoidal oscillator according to claim 2, characterized in that the filters are commutated capacitor filters operating by means of a clock signal and in that the clock signal constitutes a frequency adjustment signal.

4. A sinusoidal oscillator according to one of claims 2 and 3, characterized in that the filters are commutated capacitor filters operating by means of a clock signal and each comprises at least one capacitor in series with a switch which is not operated at the frequency of the clock signal, and in that a frequency adjustment signal of the filters is constituted by a control signal for opening or closing the switch, the central transmission frequency of the filter being modified depending on whether the switch is open or closed.

# FIG_1

OSC. — DIV. — ATT. — FILTRE

# FIG_2

10

A1

F1

12

FILTRE

E1   S1

G   AT

ATT

14

FILTRE   S2

E2   F2

R'1   R1     R'2   R2

$F_h$

# FIG_4

AT

C11   a

b

C10

a

b   AD4

FIG_3